(19) Europäisches Patentamt
European Patent Office
Office européen des brevets

(11) **EP 3 053 274 B1**

(12) **FASCICULE DE BREVET EUROPEEN**

(45) Date de publication et mention
de la délivrance du brevet:
**13.03.2019 Bulletin 2019/11**

(21) Numéro de dépôt: **14790219.1**

(22) Date de dépôt: **02.10.2014**

(51) Int Cl.:
***H03M 3/02*** *(2006.01)*    ***H03M 1/12*** *(2006.01)*
***H03M 1/48*** *(2006.01)*

(86) Numéro de dépôt international:
**PCT/FR2014/052495**

(87) Numéro de publication internationale:
**WO 2015/049466 (09.04.2015 Gazette 2015/14)**

(54) **DISPOSITIF DE QUANTIFICATION EN TEMPS CONTINU, RÉCEPTEUR DE SIGNAUX RADIOFRÉQUENCE COMPRENANT UN TEL DISPOSITIF ET PROCÉDÉ DE QUANTIFICATION EN TEMPS CONTINU**

ZEITKONTINUIERLICHE QUANTISIERUNGSVORRICHTUNG, FUNKFREQUENZSIGNALEMPFÄNGER MIT EINER DERARTIGEN VORRICHTUNG UND ZEITKONTINUIERLICHES QUANTISIERUNGSVERFAHREN

CONTINUOUS-TIME QUANTIZATION DEVICE, RADIO FREQUENCY SIGNAL RECEIVER COMPRISING SUCH A DEVICE AND CONTINUOUS-TIME QUANTIZATION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.10.2013 FR 1359635**

(43) Date de publication de la demande:
**10.08.2016 Bulletin 2016/32**

(73) Titulaire: **Commissariat à l'Énergie Atomique et aux Énergies Alternatives 75015 Paris (FR)**

(72) Inventeur: **LACHARTRE, David 38330 Montbonnot (FR)**

(74) Mandataire: **Bonnet, Michel Cabinet Bonnet 93, rue Réaumur 75002 Paris (FR)**

(56) Documents cités:
**FR-A1- 2 959 079**

• **DAVID LACHARTRE: "A 550Â[mu]W inductorless bandpass quantizer in 65 nm CMOS for 1.4-to-3GHz digial RF receivers", VLSI CIRCUITS (VLSIC), 2011 SYMPOSIUM ON, IEEE, 15 juin 2011 (2011-06-15), pages 166-167, XP032019467, ISBN: 978-1-61284-175-5**

**Description**

La présente invention concerne un dispositif de quantification en temps continu, un récepteur de signaux radiofréquence comprenant un tel dispositif et un procédé de quantification en temps continu.

Les signaux radiofréquence sont aussi généralement appelés signaux radio et par extension les récepteurs de signaux radiofréquence sont généralement qualifiés de récepteurs radio.

Dans la description et les revendications qui vont suivre, la terminologie suivante sera utilisée.

Un « signal analogique » est un signal qui peut varier de manière continue à la fois dans le temps et en amplitude.

Un « signal quantifié » est un signal qui peut varier à tout instant, mais pour ne prendre que des valeurs discrètes en amplitude.

Un « signal échantillonné » est un signal changeant de valeurs à intervalles réguliers dans le temps, c'est-à-dire à des instants discrets définis par une fréquence d'échantillonnage.

Un « signal numérique » est un signal échantillonné et quantifié, c'est-à-dire ne pouvant prendre que des valeurs discrètes, à intervalles réguliers (instants discrets) dans le temps.

Un signal « à temps continu » est un signal non échantillonné, c'est-à-dire pouvant changer de valeur n'importe quand, qu'il soit analogique ou quantifié.

Un « signal binaire » est un signal à temps continu quantifié sur deux valeurs au maximum. Un signal quantifié sur plus de deux valeurs peut être transmis sous la forme de plusieurs signaux binaires, chacun représentant un bit du signal quantifié.

« Décimer » signifie supprimer une partie des échantillons d'un signal échantillonné afin de sous échantillonner ce dernier.

Un « cycle » d'un signal binaire est la portion du signal s'étendant depuis une transition prédéterminée du signal, par exemple la transition de sa valeur haute à sa valeur basse, jusqu'à la même transition prédéterminée suivante. Dans le cas d'un signal périodique ou pseudo-périodique, un cycle correspond donc à une période ou pseudo-période du signal.

Un « dispositif de quantification », ou « quantificateur », est un dispositif qui transforme un signal analogique en un signal quantifié, c'est-à-dire qui fournit un signal quantifié dont la valeur dépend de la valeur du signal analogique au cours du temps.

L' « enveloppe positive », appelée par la suite simplement « enveloppe », d'un signal est une courbe de fréquence faible par rapport à la fréquence principale du signal et cherchant à rejoindre les pics (maxima locaux) du signal entre eux. Dans le cas d'une porteuse modulée uniquement en amplitude, l'enveloppe est la modulation d'amplitude. Un signal prenant des valeurs positives et négatives présente également une enveloppe négative cherchant à rejoindre les pics vers le bas (minima locaux) du signal entre eux. Dans le cas d'un signal symétrique par rapport à zéro, l'enveloppe négative est sensiblement égale à l'opposée de l'enveloppe positive.

Un convertisseur analogique numérique est souvent un élément essentiel des dispositifs électroniques, en particulier des récepteurs radio d'architecture numérique où le signal radio issu d'une antenne doit être numérisé.

Il existe plusieurs techniques qui présentent des compromis très différents.

L'article intitulé « 1V 5-bit 5GS/s CMOS ADC for UWB receivers », de I. Wang et S. Liu publié dans International Symposium on VLSI Design, Automation and Test, 2007, VLSI-DAT 2007, 25-27 Avril 2007, pages 1-4, propose un récepteur radio muni d'un convertisseur analogique numérique rapide qui échantillonne le signal radio à au moins deux fois sa plus haute fréquence et sur un nombre de bits relativement important. Comme le signal radio à recevoir peut avoir une dynamique supérieure à 50dB, une quantification sur au moins 8 bits peut être nécessaire. Par ailleurs, plus la fréquence radio est élevée plus la fréquence d'échantillonnage doit être grande. Par exemple un signal émis à 2,4 GHz doit être échantillonné à au moins 4,8 GS/s (i.e. taux d'échantillonnage). Un inconvénient de ce convertisseur est qu'il est très gourmant en énergie, sa puissance pouvant atteindre plusieurs watts.

Par ailleurs, l'article intitulé « A Subsampling Radio Architecture for Ultrawideband Communications », de S-W Chen et E. W. Brodersen, publié dans IEEE Transactions on Signal Processing, Volume 55, Issue 10, Oct. 2007, pages 5018-5031, propose un récepteur radio comportant un convertisseur analogique numérique conçu pour échantillonner le signal radio à moins de deux fois sa fréquence. C'est ce qui est appelé du « sous-échantillonnage ». La contrainte de vitesse du convertisseur est relâchée d'autant plus que le signal est sous-échantillonné mais au détriment de la qualité du signal converti. En particulier le sous-échantillonnage a pour effet de replier le spectre autour de la fondamentale et des harmoniques de la fréquence d'échantillonnage. Ce repliement fait apparaître dans la bande passante du signal radio des signaux parasites issus des bandes de fréquences repliées. Cette technique de conversion analogique-numérique du signal radio nécessite en général un filtrage initial pour supprimer tous les signaux parasites susceptibles de se replier. Plus le signal sera sous-échantillonné, plus le filtrage devra être resserré autour de sa bande passante. De plus, la fréquence d'échantillonnage ne pourra tout de même pas descendre en dessous de la largeur de la bande passante du signal radio au risque de la replier elle-même. Même lorsque le signal est sous-échantillonné, le problème de la quantification nécessitant un grand nombre de bits de dynamique subsiste. En outre, la fréquence d'échantillonnage ne peut pas descendre aussi bas qu'on pourrait le souhaiter.

Le nombre de bits de quantification que l'on rencontre habituellement pour convertir les signaux radio a de l'importance vis-à-vis de la complexité et donc de la consommation du traitement numérique à réaliser pour obtenir un récepteur radio complet. Ainsi, même si le convertisseur analogique numérique n'est pas la charge de consommation électrique principale, un grand nombre de bits de quantification pénalise la consommation de l'ensemble. Il est important de minimiser ce nombre quelle que soit la fréquence d'échantillonnage choisie.

Pour éviter les difficultés de l'échantillonnage, certains convertisseurs analogique numérique comportent tout d'abord un quantificateur en temps continu, le signal à temps continu n'étant échantillonné que plus tard dans la chaîne de réception.

Ainsi, le brevet français publié sous le numéro FR 2 922 388 B1 décrit un dispositif de quantification en temps continu d'un signal analogique d'entrée, pour la fourniture d'un signal de sortie à temps continu quantifié sur plusieurs bits, ce dispositif comportant :

- un circuit électronique conçu pour fournir un premier signal binaire à temps continu représentatif d'un premier bit de signe du signal de sortie, prenant à tout instant une première valeur lorsque le signal d'entrée est positif et une deuxième valeur lorsque le signal d'entrée est négatif, et
- un circuit électronique conçu pour fournir un deuxième signal quantifié à temps continu représentatif de plusieurs autres bits du signal de sortie, représentant plus précisément l'amplitude du signal analogique d'entrée.

Il est à noter que l'utilisation d'un bit pour le signe du signal présente un intérêt particulier lorsque le signal analogique d'entrée est centré autour de zéro comme c'est le cas des signaux audio ou radio par exemple. Mais ce quantificateur présente toujours l'inconvénient de nécessiter un grand nombre de bits de quantification.

Le brevet français publié sous le numéro FR 2 959 079 B1 décrit un dispositif de quantification en temps continu d'un signal analogique d'entrée, pour la fourniture d'un signal de sortie à temps continu quantifié sur plusieurs bits, comportant lui aussi un circuit électronique d'analyse de signe, conçu pour fournir un bit de signe du signal de sortie. Il comporte en outre un circuit électronique d'analyse d'enveloppe, comportant un comparateur/quantificateur à deux entrées dont l'une reçoit le signal analogique d'entrée, conçu pour fournir en sortie du comparateur/quantificateur un deuxième signal quantifié à temps continu représentatif d'au moins un deuxième bit du signal de sortie.

Plus précisément, dans ce document, le deuxième signal est un signal binaire, qualifié de bit de variation d'enveloppe, prenant une valeur haute ou basse en fonction des variations de l'enveloppe du signal analogique d'entrée. Le circuit électronique d'analyse de signe comporte alors une boucle de rétroaction à fonction d'intégration, disposée entre sa sortie et l'autre des deux entrées du comparateur/quantificateur, de manière à retrouver une estimation de l'enveloppe du signal analogique d'entrée en entrée du comparateur/ quantificateur.

Ainsi, il est possible d'obtenir un signal à temps continu quantifié sur seulement deux bits (bit de signe et bit de variation d'enveloppe), qui représente relativement fidèlement le signal analogique d'entrée. Mais l'erreur de quantification reste tout de même assez sensible. L'article intitulé "A 550 μW Inductorless Bandpass Quantizer in 65 nm CMOS for 14-to-3GHz Digital RF Receivers" décrit aussi un tel dispositif de quantification.

Il peut alors être souhaité de prévoir un quantificateur en temps continu qui, bien que présentant les avantages des quantificateurs proposés dans les documents FR 2 922 388 B1 et FR 2 959 079 B1, permette de s'affranchir d'au moins une partie des problèmes et contraintes précités.

Il est donc proposé un dispositif de quantification en temps continu d'un signal analogique d'entrée, pour la fourniture d'un signal de sortie à temps continu quantifié sur plusieurs bits, comportant :

- un circuit électronique d'analyse de signe, conçu pour fournir un premier signal binaire à temps continu représentatif d'un premier bit du signal de sortie, appelé bit de signe, prenant à tout instant une première valeur lorsque le signal d'entrée est positif et une deuxième valeur lorsque le signal d'entrée est négatif,
- un circuit électronique d'analyse d'enveloppe, comportant :

  • un comparateur/quantificateur à deux entrées dont l'une reçoit le signal analogique d'entrée, conçu pour fournir en sortie du comparateur/quantificateur un deuxième signal quantifié à temps continu représentatif d'au moins un deuxième bit du signal de sortie, appelé signal quantifié d'enveloppe, et
  • une boucle de rétroaction à conversion numérique analogique en temps continu du signal quantifié d'enveloppe, disposée entre la sortie et l'autre des deux entrées du comparateur/quantificateur,

dans lequel le signal quantifié d'enveloppe est un signal dont un filtrage passe-bas est représentatif de l'amplitude d'un signal d'enveloppe du signal d'entrée, et la boucle de rétroaction comporte un filtre passe-bas configuré de manière à reproduire, avec le comparateur/quantificateur les éléments fonctionnels d'un opérateur Sigma Delta en temps continu.

En d'autres termes, la boucle de rétroaction à conversion numérique analogique en temps continu du circuit électronique d'analyse d'enveloppe comporte un filtre passe-bas de manière à reproduire, avec le comparateur/quantificateur, les éléments fonctionnels d'un opérateur Sigma Delta en temps continu.

Par « conversion numérique analogique en temps continu », il convient de comprendre qu'il s'agit de la conversion d'un signal quantifié sur au moins un bit en un signal analogique correspondant, et non pas d'une conversion classique de signal numérique en signal analogique, puisque le signal à convertir n'est pas échantillonné.

Ainsi, grâce à l'invention et au filtrage passe-bas qu'elle propose dans la boucle de rétroaction à conversion numérique analogique en temps continu, le circuit électronique d'analyse d'enveloppe reproduit les éléments fonctionnels d'un opérateur Sigma Delta généralement utilisé en conversion analogique numérique classique, à l'exception toutefois de la fonction d'échantillonnage puisque le dispositif de quantification selon l'invention est un dispositif à temps continu n'employant aucune horloge indépendante d'échantillonnage, c'est-à-dire qu'il fournit un signal de sortie à temps continu à partir d'un signal analogique via des circuits de traitement analogique. En effet, le quantificateur du comparateur/quantificateur remplit une fonction de conversion d'un signal analogique en un signal quantifié dont un filtrage passe-bas est représentatif de l'amplitude d'un signal d'enveloppe du signal d'entrée, tandis que la boucle de rétroaction remplit la fonction inverse de conversion numérique analogique en temps continu réalisant un filtrage passe-bas. Il a été remarqué qu'en remplaçant la fonction d'intégration de la boucle de rétroaction (cf. le document FR 2 959 079 B1 qui reproduit plutôt de son côté les éléments fonctionnels d'un modulateur Delta en temps continu) par une fonction de conversion numérique analogique en temps continu à filtrage passe-bas de manière à reproduire en temps continu les éléments fonctionnels d'un opérateur Sigma Delta, un effet technique inattendu s'opère sur le signal de sortie résultant. En multipliant le bit de signe et le signal quantifié d'enveloppe, on s'aperçoit que le signal obtenu présente un spectre à harmoniques dans lequel les bandes passantes de bruit (notamment le bruit en 1/f classique produit par la boucle du circuit d'analyse d'enveloppe) s'intercalent sans se superposer aux bandes passantes de signal utile. Cet effet ne se produit pas dans le document FR 2 959 079 B1 et ce n'est pas non plus l'effet attendu d'un opérateur Sigma Delta classique.

De façon optionnelle, un dispositif de quantification en temps continu selon l'invention peut comporter un multiplieur de signaux quantifiés à temps continu, ce multiplieur recevant en entrée le bit de signe et le signal quantifié d'enveloppe et fournissant en sortie le produit en temps continu des deux signaux qu'il reçoit en entrée.

De façon optionnelle également :

- le circuit électronique d'analyse d'enveloppe est conçu pour fournir un signal binaire en sortie du comparateur/quantificateur, ce signal binaire étant représentatif d'un unique deuxième bit du signal de sortie, appelé bit d'enveloppe,
- la boucle de rétroaction est à conversion numérique analogique en temps continu et à un bit du bit d'enveloppe, et
- le multiplieur est une porte logique OU Exclusif.

Dans ce cas, le bit de signe et le signal quantifié d'enveloppe sont tous les deux des signaux binaires. Or il est toujours très délicat voire non recommandé de multiplier des signaux binaires entre eux parce que cela produit généralement un signal intermodulé présentant des harmoniques très dispersées le rendant inexploitable. Mais dans le contexte particulier du signal quantifié d'enveloppe obtenu grâce à l'invention, les deux signaux binaires obtenus sont en fait synchrones, même si l'un représente un signal modulé par une porteuse alors que l'autre représente un signal en bande de base, et produisent un signal en sortie de la porte logique qui présente des harmoniques non dispersées. Ce nouvel effet inattendu rend le signal binaire obtenu en sortie du multiplieur particulièrement avantageux et représentatif du signal analogique d'entrée.

De façon optionnelle également, le signal analogique d'entrée étant à modulation autour d'une fréquence porteuse et de bande passante inférieure à la fréquence porteuse, le filtre passe-bas présente une fréquence de coupure supérieure à la moitié de ladite bande passante.

De façon optionnelle également, le circuit électronique d'analyse de signe comporte un comparateur asynchrone.

De façon optionnelle également, le comparateur/quantificateur du circuit électronique d'analyse d'enveloppe comporte un comparateur à effet mémoire.

De façon optionnelle également, le comparateur/quantificateur du circuit électronique d'analyse d'enveloppe comporte :

- un comparateur asynchrone, et
- une bascule RS dont une première entrée est raccordée en sortie du comparateur asynchrone du circuit électronique d'analyse d'enveloppe et une deuxième entrée est raccordée en sortie du circuit électronique d'analyse de signe.

De façon optionnelle également, le comparateur/quantificateur du circuit électronique d'analyse d'enveloppe est suivi, dans le circuit électronique d'analyse d'enveloppe, par une bascule D présentant une entrée d'horloge alimentée par le bit de signe fourni par le circuit électronique d'analyse de signe.

Il est également proposé un récepteur de signaux radiofréquence comportant :

- une antenne conçue pour capter un signal radiofréquence et le convertir en un signal électrique,
- un dispositif de quantification en temps continu selon l'invention pour quantifier en temps continu un signal analogique d'entrée obtenu à partir du signal électrique fourni par l'antenne,

- un circuit électronique d'oscillateur radio local, conçu pour générer deux signaux d'oscillation locale en quadrature l'un de l'autre, et
- un circuit électronique double mélangeur, conçu pour fournir deux signaux électriques binaires de bande de base en quadrature l'un de l'autre, ces deux signaux de bande de base correspondant au mélange du produit du bit de signe et du signal quantifié d'enveloppe avec respectivement les deux signaux d'oscillation locale.

Il est également proposé un procédé de quantification selon la revendication 10.

L'invention sera mieux comprise à l'aide de la description qui va suivre, donnée uniquement à titre d'exemple et faite en se référant aux dessins annexés dans lesquels :

- la figure 1 représente schématiquement un dispositif de quantification en temps continu, selon un premier mode de réalisation de l'invention,
- la figure 2 illustre les étapes successives d'un procédé de quantification en temps continu selon l'invention, mis en oeuvre par le dispositif de quantification de la figure 1,
- la figure 3 illustre schématiquement le spectre typique d'un signal résultant d'un traitement d'un signal analogique d'entrée par le dispositif de quantification de la figure 1,
- la figure 4 représente schématiquement un dispositif de quantification en temps continu, selon un deuxième mode de réalisation de l'invention,
- les figures 5A et 5B illustrent, à l'aide de diagrammes, l'évolution au cours du temps de signaux électriques en différents points du dispositif de quantification de la figure 3 lors de son fonctionnement,
- la figure 6 est un graphe illustrant l'erreur de quantification produite par un dispositif de quantification tel que celui de la figure 1 ou 4,
- les figures 7A et 7B représentent schématiquement deux modes de réalisation d'un dispositif de conversion numérique analogique en temps continu du dispositif de quantification de la figure 1 ou 4, et
- les figures 8A et 8B représentent schématiquement deux modes de réalisation d'un récepteur de signaux radiofréquence selon l'invention.

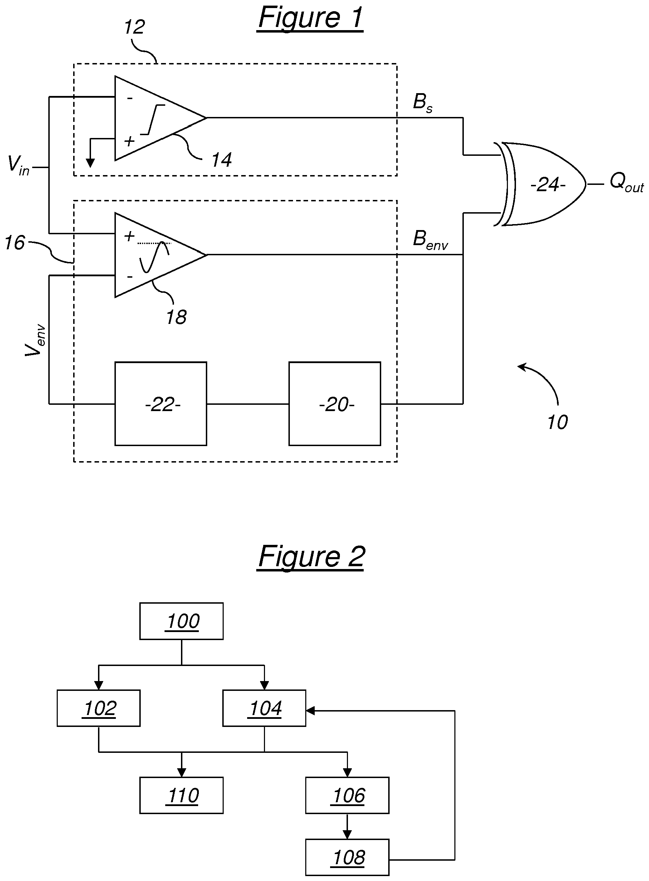

Le dispositif 10 de quantification en temps continu illustré sur la figure 1 comporte une entrée recevant un signal analogique $V_{in}$ pour la fourniture d'un signal de sortie à temps continu quantifié sur plusieurs bits, par exemple sur deux bits. Dans l'exemple décrit, le signal de sortie est composé de deux signaux électriques binaires à temps continu (appelés aussi signaux logiques), appelés respectivement bit de signe $B_s$ et bit d'enveloppe $B_{env}$, ce deuxième signal étant plus généralement un signal quantifié porteur d'informations sur l'enveloppe du signal d'entrée $V_{in}$. Il est imposé, dans le cadre de cette invention, que le deuxième signal quantifié $B_{env}$ puisse à chaque instant permettre une estimation de l'amplitude de l'enveloppe du signal d'entrée $V_{in}$ par filtrage passe-bas sur une fenêtre temporelle prédéterminée.

A cet effet, le dispositif de quantification 10 comporte tout d'abord un circuit électronique 12 d'analyse de signe, conçu pour fournir le bit de signe $B_s$ du signal de sortie. Ce bit de signe $B_s$ prend une valeur haute lorsque le signal d'entrée $V_{in}$ est positif et une valeur basse lorsque le signal d'entrée $V_{in}$ est négatif. Il est donc représentatif à tout instant du signe du signal d'entrée $V_{in}$. Dans l'exemple décrit, le circuit 12 d'analyse de signe comporte un comparateur asynchrone 14 dont l'entrée analogique négative reçoit le signal d'entrée $V_{in}$, dont l'entrée analogique positive est connectée à une masse électrique du dispositif de quantification 10 et dont la sortie binaire fournit le bit de signe $B_s$. Un comparateur asynchrone est un comparateur conçu pour fournir à tout instant le résultat de la comparaison de ses entrées analogiques sur sa sortie logique binaire, sans nécessiter d'horloge indépendante, de sorte que cette sortie n'est pas échantillonnée. Le comparateur 14 est ainsi conçu pour comparer le signal d'entrée $V_{in}$ à la masse électrique et pour fournir le bit de signe $B_s$ en fonction du résultat de la comparaison.

Le dispositif de quantification 10 comporte en outre un circuit électronique 16 d'analyse d'enveloppe, conçu pour fournir le bit d'enveloppe $B_{env}$ du signal de sortie. Le circuit 16 d'analyse d'enveloppe est dans cet exemple conçu pour comparer à tout instant le signal d'entrée $V_{in}$ à une estimation $V_{env}$ de son enveloppe (i. e. l'enveloppe positive définie précédemment). Il remplit ainsi une fonction de détection de crête. Le bit d'enveloppe $B_{env}$ prend alors une valeur haute lorsque le signal d'entrée $V_{in}$ est supérieur à son enveloppe $V_{env}$ et une valeur basse dans le cas contraire. Il est donc représentatif à tout instant de l'enveloppe du signal d'entrée $V_{in}$. Plus précisément, compte tenu de ce qui est imposé pour ce signal dans le cadre de l'invention, il est constitué d'une succession de valeurs dont un filtrage passe-bas, sensiblement proche d'une moyenne glissante, est représentatif de l'amplitude de l'enveloppe du signal d'entrée en étant à chaque instant proportionnelle à cette amplitude. D'une façon plus générale, le résultat de la détection de crête pourrait être quantifié sur plusieurs bits de manière à fournir un signal quantifié d'enveloppe plus précis que le bit d'enveloppe $B_{env}$, mais la quantification de ce signal sur un seul bit fournit malgré tout des résultats satisfaisants.

Pour réaliser la fonction de détection de crête, le circuit 16 d'analyse d'enveloppe comporte, dans une branche principale, un comparateur/quantificateur 18 qui peut prendre la forme, dans le cas de la figure 1 où le signal quantifié d'enveloppe est le bit d'enveloppe $B_{env}$, d'un simple comparateur à effet mémoire et à sortie binaire. L'entrée analogique positive de ce comparateur/quantificateur 18 reçoit le signal d'entrée $V_{in}$.

Le circuit 16 d'analyse d'enveloppe comporte en outre une boucle de rétroaction à conversion numérique analogique en temps continu du bit d'enveloppe $B_{env}$, disposée entre la sortie binaire et l'entrée analogique négative du comparateur/quantificateur 18.

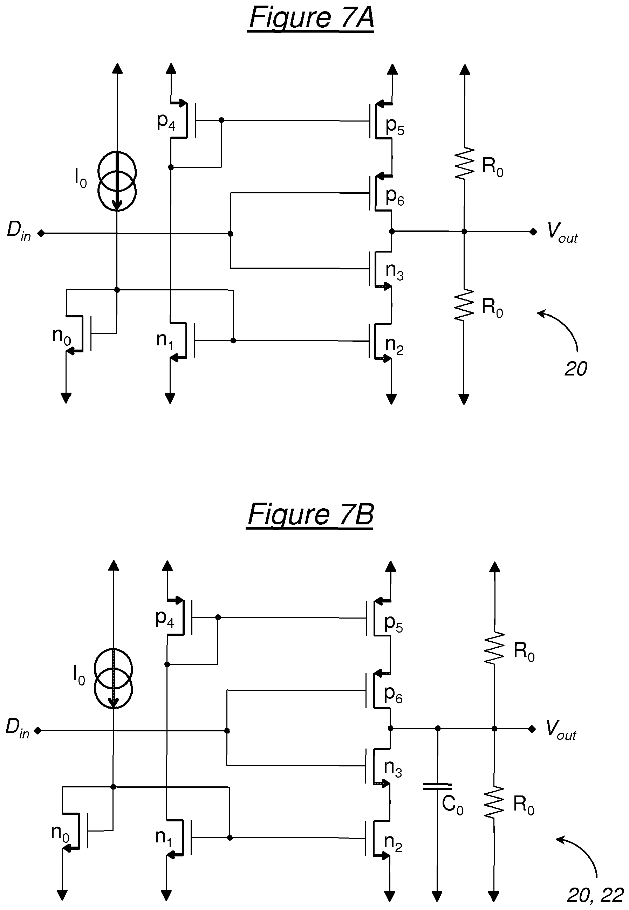

Cette boucle de rétroaction comporte de façon optionnelle un élément 20 de conversion numérique analogique en temps continu réalisant une transposition de signal, c'est-à-dire un élément électronique de traitement analogique convertissant le bit d'enveloppe $B_{env}$, qui est un signal binaire à temps continu, en un signal analogique correspondant mais dont les valeurs minimale et maximale sont transposées de manière à encadrer les valeurs minimale et maximale de l'enveloppe $V_{env}$ du signal d'entrée $V_{in}$. Autrement dit, la conversion réalise une transposition de sorte que la valeur maximale du signal obtenu en sortie de l'élément de conversion 20 soit supérieure ou égale à la valeur maximale de l'enveloppe $V_{env}$ et que la valeur minimale du signal obtenu en sortie de l'élément de conversion 20 soit inférieure ou égale à la valeur minimale de l'enveloppe $V_{env}$. Un mode de réalisation de cet élément de conversion 20 sera détaillé en référence à la figure 7A. Un tel élément de conversion 20 à fonction de transposition n'est pas indispensable si le bit d'enveloppe $B_{env}$ est déjà porté, en sortie du comparateur/quantificateur 18, par un signal en temps continu dont la valeur maximale est supérieure ou égale à la valeur maximale de l'enveloppe $V_{env}$ et dont la valeur minimale est inférieure ou égale à la valeur minimale de l'enveloppe $V_{env}$.

La boucle de rétroaction à conversion numérique analogique en temps continu comporte en outre un filtre passe-bas 22 disposé en sortie de la transposition numérique analogique en temps continu le cas échéant, ou directement en sortie du comparateur/quantificateur 18 (via un circuit électronique tampon d'adaptation d'impédance ou d'admittance) s'il n'y a pas d'élément de conversion 20. C'est ce filtre passe-bas qui fournit l'estimation $V_{env}$ de l'enveloppe du signal d'entrée $V_{in}$ en sortie de la boucle de rétroaction. Une implémentation de ce filtre passe-bas 22 dans un autre mode de réalisation possible de l'élément de conversion 20 sera détaillée en référence à la figure 7B. Ce filtre passe-bas 22 est *a minima* un filtre RF de premier ordre. Un tel filtre passe-bas ne peut notamment pas être confondu avec un intégrateur. Contrairement à un intégrateur, il présente une fréquence de coupure à - 3 dB prédéterminée $f_c$ en deçà de laquelle le gain du filtre est sensiblement constant (i. e. entre 0 et -3 dB) par rapport à une valeur maximale de gain $G_{max}$ et au-delà de laquelle le gain du filtre est toujours inférieur à $G_{max}$ - 3 dB.

Le dispositif de quantification 10 comporte en outre un multiplieur 24 de signaux à temps continu recevant le bit de signe $B_s$ du signal de sortie fourni par le circuit 12 d'analyse de signe et le bit d'enveloppe $B_{env}$ du signal de sortie fourni par le circuit 16 d'analyse d'enveloppe. Ce multiplieur 24 fournit en sortie un signal binaire à temps continu dont la valeur à chaque instant est le produit des valeurs au même instant des signaux $B_s$ et $B_{env}$. Ce signal résultant, noté $Q_{out}$, sera appelé par la suite signal de sortie mixé ou bit de sortie. Dans l'exemple de la figure 1, où les deux signaux $B_s$ et $B_{env}$ sont binaires, le multiplieur peut prendre la forme d'une simple porte logique OU Exclusif.

Le fonctionnement du dispositif de quantification 10 va maintenant être décrit en référence à la figure 2.

Au cours d'une première étape 100, le dispositif de quantification 10 reçoit le signal analogique d'entrée $V_{in}$.

Au cours d'une étape 102, le comparateur asynchrone 14 compare le signal d'entrée $V_{in}$ à la masse pour fournir le bit de signe $B_s$.

Au cours d'une étape 104, le comparateur/quantificateur 18 compare le signal d'entrée $V_{in}$ au signal d'enveloppe $V_{env}$ retourné par la boucle de rétroaction pour fournir le bit d'enveloppe $B_{env}$. Ce signal d'enveloppe $V_{env}$ est représentatif de l'enveloppe du signal d'entrée $V_{in}$ au cours d'un cycle précédent, la boucle de rétroaction engendrant en effet un décalage de cycle.

Au cours d'une étape 106, l'élément de conversion 20 de la boucle de rétroaction à conversion numérique analogique en temps continu transpose, le cas échéant, le signal en temps continu supportant le bit d'enveloppe d'un cycle précédent en un signal analogique dont les valeurs maximale et minimale encadrent les valeurs maximale et minimale du signal d'enveloppe $V_{env}$.

Au cours d'une étape 108 suivant l'étape 106, le filtre passe-bas 22 filtre ce signal analogique transposé pour fournir l'estimation $V_{env}$ précitée. L'étape 108 est suivie, avec un décalage de cycle, par un retour à l'étape 104.

Les étapes 104, 106 et 108 constituent ainsi une boucle d'étapes effectuant l'opération de type Sigma Delta en temps continu du circuit d'analyse d'enveloppe 16. La différence relevée par le comparateur/quantificateur 18 entre le signal d'entrée $V_{in}$ et le signal d'enveloppe $V_{env}$ représente l'erreur de quantification produite dans l'enchaînement des conversions analogique-quantifié-analogique réalisées par cette boucle d'étapes. En choisissant des conversions à un bit, l'erreur de quantification est importante, mais le filtrage réalisé à l'étape 108 réduit considérablement sa puissance à haute fréquence, ce qui correspond à une partie du spectre où se trouve l'essentiel de l'erreur de quantification.

Enfin, au cours d'une étape 110, la porte logique OU Exclusif 24 multiplie le bit de signe $B_s$ et bit d'enveloppe $B_{env}$ pour fournir le bit de sortie $Q_{out}$. Cette étape a pour effet de translater en fréquence le spectre du signal binaire d'enveloppe $B_{env}$ autour de la fréquence fondamentale et des harmoniques du bit de signe $B_s$.

On notera que pour rendre le dispositif de quantification 10 le plus efficace possible, l'enveloppe $V_{env}$ n'est estimée que sur les maximas d'une seule polarité (en l'occurrence positive). Les conséquences sont que la bande-passante de l'enveloppe estimée ne dépasse pas la moitié de la fréquence centrale et qu'il en est de même pour le spectre de bruit. Il n'y a alors pas de risque de replier le bruit sur le signal utile quand le bit d'enveloppe $B_{env}$ est multiplié par le bit de signe $B_s$ à l'étape 110.

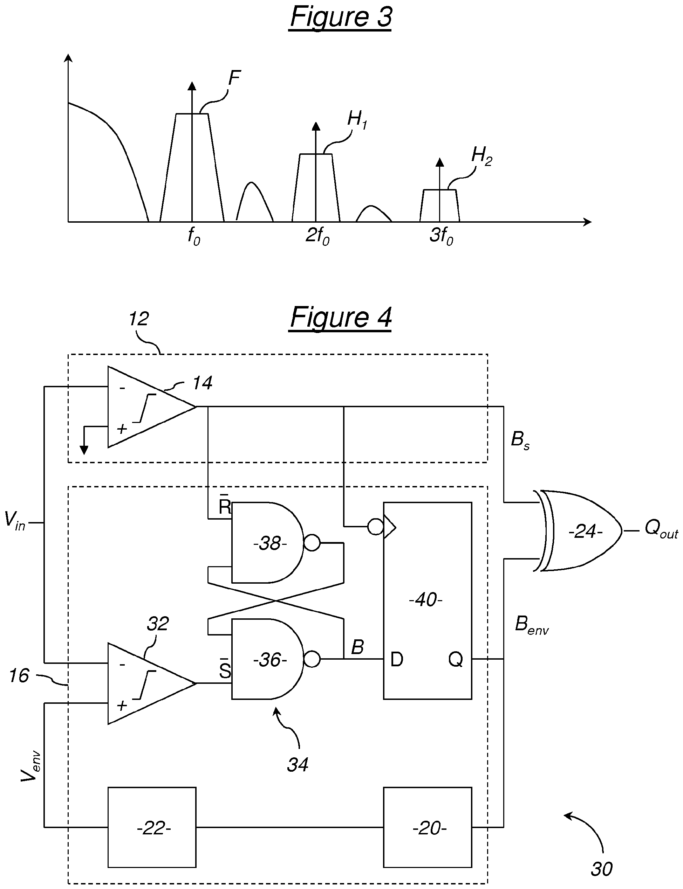

La figure 3 illustre schématiquement la forme générale d'un spectre typique du bit de sortie $Q_{out}$ obtenu à partir d'un signal analogique d'entrée de type radiofréquence, c'est-à-dire à bande relativement étroite autour d'une fréquence porteuse $f_0$ élevée. Par effet de la quantification réalisée par le dispositif 10, ce bit de sortie $Q_{out}$ présente un spectre à fondamentale F (autour de la fréquence porteuse $f_0$) et harmoniques multiples $H_1$ (autour de la fréquence $2.f_0$), $H_2$ (autour de la fréquence $3.f_0$), etc. Par ailleurs, par effet de la boucle de rétroaction du circuit 16 d'analyse d'enveloppe qui permet la réalisation d'une opération de type Sigma Delta en temps continu, on remarque que le bruit ne se mélange pas au signal utile. Le spectre du signal $Q_{out}$ comporte une alternance de bandes de fréquences relatives à du bruit et à du signal, sans que ces bandes de fréquences ne se recouvrent, même partiellement. Ainsi, de part et d'autre de chaque harmonique du signal utile se trouve une bande de bruit qui ne déborde pas sur cette harmonique. Il est alors très facile de sélectionner la bande de fréquence fondamentale du signal utile disposée autour de la fréquence porteuse connue $f_0$, à l'aide d'un simple filtrage passe bande adapté autour de cette fréquence porteuse. Ce filtrage pourra se faire numériquement après numérisation dans la chaine de numérisation qui suit la quantification réalisée par le dispositif 10 pour l'obtention d'une bonne approximation du signal d'entrée $V_{in}$.

Le dispositif 30 de quantification en temps continu illustré sur la figure 4 diffère du dispositif de quantification 10 par la branche principale de comparaison/quantification du circuit 16 d'analyse d'enveloppe.

Conformément à ce deuxième mode de réalisation, la branche principale comporte un comparateur asynchrone 32, identique au comparateur asynchrone 14, dont l'entrée analogique négative reçoit le signal d'entrée $V_{in}$, dont l'entrée analogique positive reçoit l'estimation d'enveloppe $V_{env}$ en sortie de la boucle de rétroaction et dont la sortie binaire fournit continûment un bit de comparaison de ces deux signaux.

Ce bit de comparaison des signaux $V_{in}$ et $V_{env}$ alimente l'entrée $\overline{S}$ d'une bascule RS 34 dont l'entrée $\overline{R}$ est elle-même alimentée par la sortie du comparateur asynchrone 14, c'est-à-dire par le bit de signe $B_s$. Dans l'exemple de la figure 4, la bascule RS 34 est réalisée à l'aide de deux portes logiques NON-ET 36 et 38 comme cela est connu en soi. Elle fournit en sortie un signal à temps continu B correspondant au bit de comparaison des signaux $V_{in}$ et $V_{env}$ dans lequel une valeur haute apparaissant dans un cycle du bit de signe $B_s$ est mémorisée, c'est-à-dire prolongée, jusqu'à la fin de ce cycle.

En variante, l'ensemble constitué du comparateur asynchrone 32 et de la bascule RS 34 peut être remplacé par un comparateur à effet mémoire, comme dans le premier mode de réalisation, fournissant directement le signal B.

Conformément au deuxième mode de réalisation, la branche principale du circuit 16 d'analyse d'enveloppe comporte en outre un élément de maintien 40, conçu pour fournir le bit d'enveloppe $B_{env}$ de telle sorte qu'il corresponde au signal B dans lequel, pour chaque cycle du bit de signe $B_s$, la valeur du signal B du début du cycle est capturée et maintenue jusqu'à la fin du cycle. Ainsi, comme le signal de signe $B_s$ ne dépend de rien d'autre que du signal d'entrée $V_{in}$, le bit d'enveloppe $B_{env}$ demeure quantifié en temps continu et n'est donc affecté par aucun repliement de spectre. Dans l'exemple décrit, la capture est réalisée sur les fronts descendants du signal de signe $B_s$. Ainsi, dans l'exemple de la figure 4, l'élément de maintien 40 est une bascule D conçue pour échantillonner sur les fronts descendants de son entrée d'horloge. Son entrée D est connectée à la sortie B de la bascule RS 34, son entrée d'horloge est connectée à la sortie du comparateur asynchrone 14, c'est-à-dire qu'elle est commandée par le bit de signe $B_s$, et sa sortie Q fournit le bit d'enveloppe $B_{env}$. Il en résulte que le bit d'enveloppe $B_{env}$ peut être considéré comme « pseudo échantillonné » à l'aide du bit de signe $B_s$.

Ainsi, la bascule RS 34 et l'élément de maintien 40 forment un circuit électronique conçu pour fournir le bit d'enveloppe $B_{env}$ de sorte qu'il prenne sa valeur haute sur tout un cycle du bit de signe $B_s$ lorsque le bit de comparaison des signaux $V_{in}$ et $V_{env}$ a pris sa valeur haute sur au moins une partie du cycle précédent du bit de signe $B_s$, et sa valeur basse sinon.

Ce deuxième mode de réalisation présente l'avantage de fournir un bit d'enveloppe dont les transitions d'une valeur à l'autre sont espacées d'une durée toujours au moins égale à la période de la porteuse. Ainsi, les valeurs du bit d'enveloppe $B_{env}$ se propagent correctement en sortie du dispositif de quantification 30.

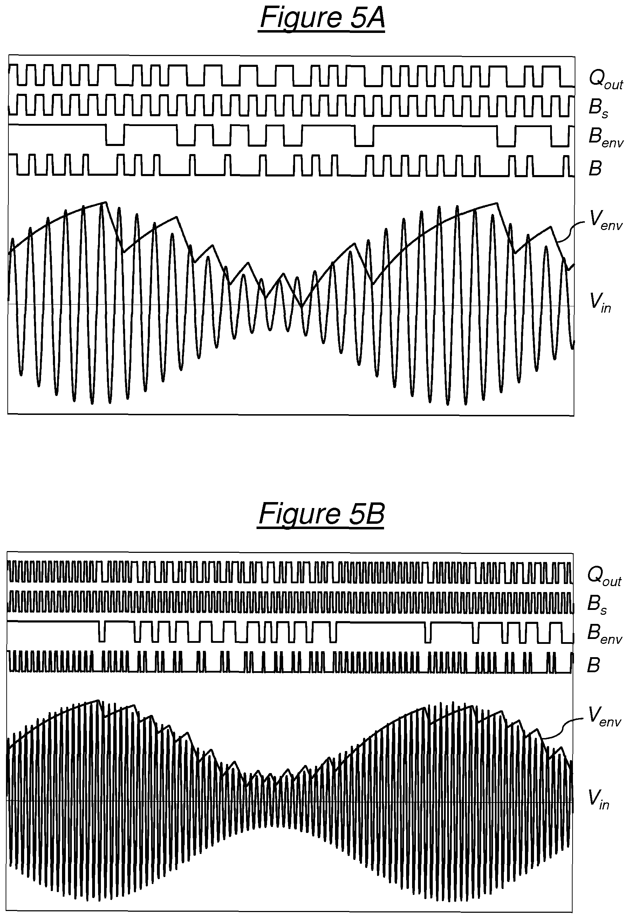

Pour illustrer plus concrètement le fonctionnement du dispositif de quantification 30, les variations au cours du temps d'un signal d'entrée radiofréquence $V_{in}$, de l'estimation $V_{env}$ de l'enveloppe de ce signal d'entrée, du signal binaire B de comparaison du signal d'entrée $V_{in}$ et de l'estimation $V_{env}$, du bit d'enveloppe $B_{env}$, du bit de signe $B_s$ et du bit de sortie résultant $Q_{out}$ sont représentées à l'aide de chronogrammes sur la figure 5A dans le cas d'un signal d'entrée à large bande spectrale et sur la figure 5B dans le cas d'un signal d'entrée à bande spectrale étroite. On peut constater que l'écart entre l'enveloppe estimée $V_{env}$ par la boucle de rétroaction et le signal d'entrée $V_{in}$ est plus important pour un signal à large bande que pour un signal à bande étroite. On peut généraliser cette observation en considérant que grâce à la conversion Sigma Delta en temps continu détaillée précédemment, plus un signal radiofréquence possède une bande de fréquence étroite autour de sa porteuse, plus la précision du dispositif de quantification 10 ou 30 est grande.

On va à présent estimer l'erreur de quantification produite par le circuit 16 d'analyse d'enveloppe dans l'exemple de la figure 1 ou 4, c'est-à-dire lorsque le signal d'enveloppe est quantifié sur un seul bit, dans le cas où le signal d'entrée $V_{in}$ est formé d'une porteuse de période $T_0$ (fréquence de porteuse $f_0$ et pulsation de porteuse $\omega_0$) modulée en amplitude. L'amplitude de la porteuse non modulée est notée $A_0$ et M(t) est la fonction de modulation à valeur dans [0,1] et qui a une bande passante notée BW, inférieure à $f_0$. Le signal d'entrée $V_{in}$ est ainsi de la forme $V_{in} = A_0.M(t).\sin(\omega_0.t)$.

Dans ces conditions, la fréquence de coupure $f_c$ du filtre passe-bas 22 doit être de préférence choisie de manière à quantifier la fonction de modulation M(t) et non la porteuse. Pour que la bande passante BW ne soit pas tronquée par ce filtrage passe-bas, il faut que la relation $f_0 > 2.f_c \geq$ BW soit vérifiée. Si le filtre passe-bas 22 est d'ordre 1 et que l'élément de conversion 20 à un bit génère une tension de sortie $V_{DAC}$, alors $P = \pi. f_c. V_{DAC}$ est la pente du signal $V_{env}$ qui est comparé au signal d'entrée $V_{in}$. Pour éviter la saturation, il faut que $V_{DAC}$ soit supérieure ou égale à $A_0$.

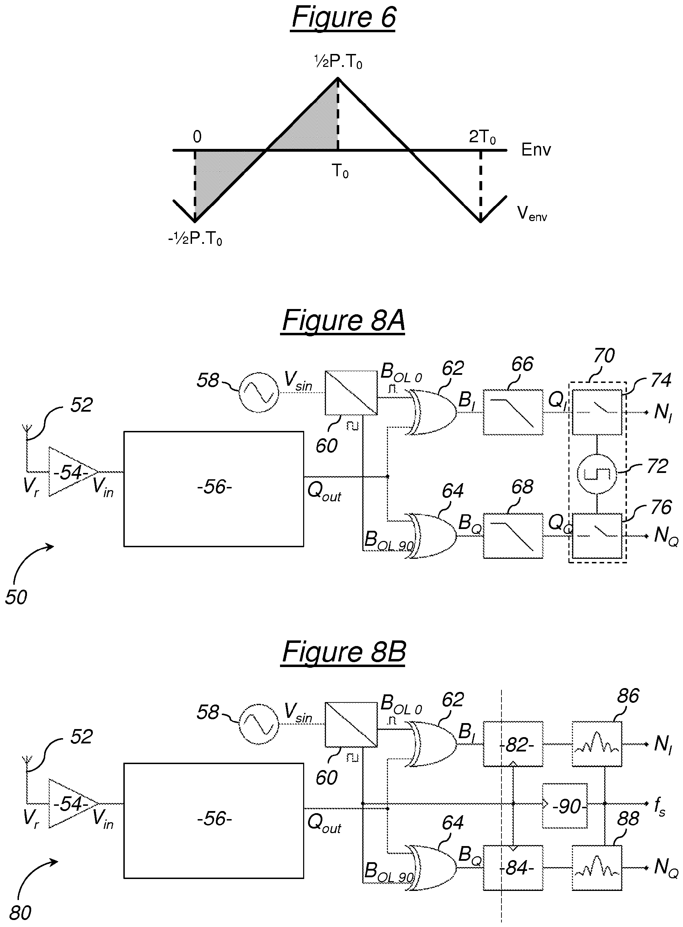

La figure 6 représente l'évolution au cours du temps de l'enveloppe théorique, notée Env, c'est-à-dire de la modulation d'amplitude, supposée constante sur cette figure, et du signal d'enveloppe $V_{env}$ obtenu en sortie de la boucle de rétroaction, c'est-à-dire plus précisément en sortie du filtre passe-bas 22.

Comme on peut le voir sur cette figure, l'erreur de quantification (aire hachurée) est la conséquence de l'approximation de l'enveloppe théorique du signal d'entrée $V_{in}$ par un signal triangulaire de pentes +P et -P. Entre deux instants 0 et $T_0$, cette courbe s'exprime par : $P.t - \frac{1}{2}P.T_0$. On remarque que compte tenu de l'expression de P, plus $f_c$ et $V_{DAC}$ sont petits, plus l'erreur de quantification est faible.

Le bruit équivalent de quantification en valeur RMS est donné par :

$$\sigma = \sqrt{\frac{P^2}{T_0}\int_0^{T_0}(t - T_0/2)^2.dt} = \frac{P.T_0}{\sqrt{12}}$$

On peut ainsi constater qu'on a le même bruit équivalent de quantification qu'un convertisseur analogique numérique classique pour lequel $\sigma = \frac{\text{LSB}}{\sqrt{12}}$. Le facteur $P.T_0$, qui est la variation d'amplitude minimale, est l'équivalent du LSB d'un convertisseur analogique numérique classique.

Le rapport signal à bruit de la quantification peut donc être déterminé pour un signal d'amplitude $A_0$ par :

$$SNR = \frac{\sqrt{6}}{\pi}.\frac{f_0}{f_c}.\frac{A_0}{V_{DAC}}$$

et

$$SNR_{MAX} = \frac{\sqrt{6}}{\pi}.\frac{f_0}{f_c}.$$

On voit que pour augmenter le rapport signal à bruit, il est intéressant d'augmenter la fréquence porteuse et de diminuer la largeur de bande, la largeur de bande maximale étant fixée par le choix de $f_c$.

Par exemple, en utilisant un dispositif de quantification en temps continu selon l'invention dans le cadre du standard ZigBee dans lequel la bande de fréquences s'étend d'environ 2,4 GHz à 2,48 GHz, le rapport signal à bruit dans cette bande de 80 MHz atteint au moins 33 dB. Chaque canal d'émission faisant environ 2 MHz de largeur, on atteint plus de 65 dB de rapport signal à bruit par canal, c'est-à-dire l'équivalent de plus de 10 bits d'un convertisseur Flash tournant à au moins 5 GS/s.

On comprend alors qu'il est intéressant de choisir la valeur de $f_c$ de façon à englober toute la bande de fréquences susceptible de contenir du signal utile. La quantification se fait avec un rapport signal à bruit moyen. Ensuite, le filtrage d'un canal plus étroit dans cette bande de fréquences permet d'obtenir un rapport signal à bruit plus élevé uniquement pour le signal souhaité.

La figure 7A représente un exemple de réalisation de l'élément de conversion 20 de la figure 1 ou 4, c'est-à-dire un convertisseur « numérique » analogique en temps continu et à un bit réalisant une transposition de signal. Un signal binaire $D_{in}$ fourni en entrée de ce convertisseur à un bit est traité pour en sortir sous la forme d'un signal analogique correspondant $V_{out}$. Plus précisément, le convertisseur à un bit 20 génère à tout instant une tension $V_{DAC}$ positive quand son entrée binaire $D_{in}$ est à 1 et une tension $-V_{DAC}$ négative quand son entrée binaire $D_{in}$ est à 0. La valeur absolue commune $V_{DAC}$ de ces deux tensions se situe nominalement autour de la moitié de la tension d'alimentation du convertisseur.

La génération des tensions $V_{DAC}$ et $-V_{DAC}$ est réalisée par un courant $+I_0$ ou $-I_0$, initialement engendré par une source de courant de polarisation $I_0$ disposée en entrée, dans deux résistances $R_0$ sur la sortie $V_{out}$. Un transistor $n_2$ forme la source de courant $-I_0$ en tirant le courant vers 0 V (i.e. la masse) tandis qu'un transistor $p_5$ fournit le courant $+I_0$ car issu de l'alimentation. Des transistors supplémentaires $n_0$, $n_1$ et $p_4$ sont disposés comme illustré sur la figure 7A de sorte que les paires de transistors $(n_0,n_2)$, $(n_0,n_1)$ et $(p_4,p_5)$ forment des miroirs de courant qui recopient le courant de polarisation $I_0$. D'autres transistors $p_6$ et $n_3$ fonctionnent en commutateurs commandés par l'entrée binaire $D_{in}$. Quand $D_{in}$ est à 1, le transitor $p_6$ est bloqué et ne laisse pas passer le courant issu du transistor $p_5$. Par contre, le transistor $n_3$ est rendu passant et laisse passer le courant vers le transistor $n_2$. Réciproquement quand $D_{in}$ est à 0, le transistor $p_6$ est passant et le transistor $n_3$ bloqué. Le courant

$I_0$ est converti en tension par les deux résistances $R_0$ en parallèle sur la sortie $V_{out}$ de sorte que $V_{DAC} = \frac{1}{2}R_0.I_0$. Il est ainsi avantageusement possible de régler la valeur du courant $I_0$ pour que la valeur $V_{DAC}$ soit toujours supérieure ou égale à l'amplitude du signal d'enveloppe $V_{env}$.

La figure 7B représente une variante de l'exemple de la figure 7A, dans laquelle le filtre passe-bas 22 est simplement intégré dans l'élément de conversion 20. Pour réaliser cette insertion, il suffit de connecter un condensateur $C_0$ sur la sortie $V_{out}$. En effet, grâce à la haute impédance des transistors sources de courant, l'impédance de sortie du convertisseur est très proche de $\frac{1}{2}R_0$, de sorte que la connexion du condensateur $C_0$ sur la sortie $V_{out}$ crée un filtre passe-bas d'ordre 1 dont la fréquence de coupure vaut :

$$f_c = \frac{1}{\pi.R_0C_0}$$

Bien que le dispositif de quantification de la figure 1 ou 4 ne soit pas limité à une utilisation radiofréquence, il va maintenant être décrit son intégration dans un récepteur de signaux radiofréquence en référence aux figures 8A et 8B. En effet, le dispositif de quantification de l'invention peut être utilisé dans d'autres dispositifs, tels que par exemple les convertisseurs des signaux audio, capteurs de mouvements et de phénomènes vibratoires, et en particulier ceux comportant un convertisseur analogique numérique. L'homme du métier saura adapter le dispositif de quantification de l'invention à ces applications. Mais il est vrai que ce dispositif est particulièrement bien adapté aux applications de réception radio puisque les signaux radiofréquence reçus possèdent un spectre décalé en fréquence avec une largeur de bande plus étroite que ce décalage.

En référence à la figure 8A, un récepteur 50 de signaux radiofréquence selon un premier mode de réalisation de l'invention comporte tout d'abord une antenne 52 conçue pour capter un signal radiofréquence et le convertir en un signal électrique noté $V_r$. Dans l'exemple décrit, le récepteur 50 est un récepteur dit IQ à zéro IF, c'est-à-dire à fréquence intermédiaire nulle. Le signal radiofréquence comporte une porteuse de fréquence élevée (typiquement de 30 KiloHertz à 100 GigaHertz), modulée par un signal porteur de l'information à transmettre, se trouvant généralement dans des fréquences très inférieures à celles de la porteuse.

Le récepteur 50 comporte en outre un amplificateur 54 conçu pour amplifier le signal $V_r$ avec une faible contribution en bruit, tel qu'un amplificateur de type LNA (pour Low Noise Amplifier). A cet effet, l'amplificateur 54 est muni d'une entrée connectée à l'antenne radio 52 et d'une sortie fournissant le signal électrique analogique d'entrée $V_{in}$ mentionné en référence aux figures 1 et 4.

Le récepteur 50 comporte en outre un dispositif 56 de quantification en temps continu du signal d'entrée $V_{in}$ pour la fourniture du bit de sortie à temps continu $Q_{out}$ mentionné en référence aux figures 1 et 4. Le dispositif de quantification 56 peut donc être constitué de l'un des deux dispositifs 10 et 30 décrits précédemment.

Le récepteur 50 comporte en outre un oscillateur local 58, dont la sortie fournit un signal $V_{sin}$ qui est logique carré de valeurs -1 et +1, et un circuit électronique 60 de déphasage, dont l'entrée est connectée à la sortie de l'oscillateur local 58 et dont les deux sorties fournissent respectivement des signaux d'oscillation locale en phase $B_{OL\,0}$ et en quadrature $B_{OL\,90}$.

Le récepteur 50 comporte en outre un dispositif électronique, appelé double mélangeur, conçu pour mélanger le bit de sortie à temps continu $Q_{out}$ avec respectivement les deux signaux d'oscillation locale $B_{OL\,0}$ et $B_{OL\,90}$. Par « mélanger », on entend une opération dont le résultat fournit un signal présentant au moins une fréquence égale à la différence des fréquences des deux signaux mélangés et qui forme la bande de base dans un récepteur zéro IF. La bande de base est la bande de fréquences que possède le signal (indivisible) une fois démodulé ou, de façon équivalente, avant qu'il ne soit modulé. Le signal obtenu par mélange présente en outre une fréquence à la somme des fréquences des deux signaux mélangés, qui sera filtrée comme cela sera expliqué par la suite. Le double mélangeur fournit ainsi deux signaux binaires mélangés respectivement en phase $B_I$ et en quadrature $B_Q$ correspondant aux deux mélanges précédents.

Dans l'exemple de la figure 8A, le double mélangeur comporte deux multiplieurs, appelés respectivement multiplieurs en phase 62 et en quadrature 64, présentant chacun une entrée recevant le bit de sortie $Q_{out}$ et une autre entrée recevant, pour le multiplieur en phase 62, le signal d'oscillation locale en phase $B_{OL\,0}$, et, pour le multiplieur en quadrature 64, le signal d'oscillation locale en quadrature $B_{OL\,90}$. Dans cet exemple également, les multiplieurs en phase 62 et en quadrature 64 sont de simples portes logiques OU Exclusif puisque les signaux multipliés entre eux sont tous binaires.

Le récepteur 50 comporte en outre deux filtres passe-bas, appelés filtres passe-bas respectivement de phase 66 et de quadrature 68, munis d'entrées respectivement connectées à la sortie du multiplieur en phase 62 et à la sortie du multiplieur en quadrature 64 et de sorties fournissant des signaux quantifiés, appelés signaux quantifiés de bande de base respectivement en phase $Q_I$ et en quadrature $Q_Q$. Dans l'exemple décrit, les filtres passe-bas 66 et 68 sont des filtres numériques à temps continu, c'est-à-dire que le signal de sortie est quantifié mais non échantillonné. En variante, les filtres passe-bas 66, 68 pourraient être des filtres analogiques, par exemple de type RC, fournissant des signaux analogiques de bande de base respectivement en phase et en quadrature.

Les filtres passe-bas 66, 68 sont en outre des filtres anti-repliement, c'est-à-dire qu'ils ont pour fonction de réduire l'effet de repliement risquant de se produire dans un double échantillonneur 70 du récepteur 50 qui sera décrit ci-dessous. A cet effet, la fréquence de coupure des filtres passe-bas 66, 68 est choisie inférieure à la moitié de la fréquence d'échantillonnage. Ainsi, les filtres passe-bas 66, 68 ne traitent que le problème du repliement. En particulier, ils ne réalisent pas nécessairement la fonction de filtrage de canal.

Le double échantillonneur 70 est conçu pour échantillonner à basse fréquence les deux signaux quantifiés de bande de base $Q_I$ et $Q_Q$ afin de fournir deux signaux numériques de bande de base en phase $N_I$ et en quadrature $N_Q$.

Dans l'exemple de la figure 8A, le double échantillonneur 70 comporte une horloge 72 munie d'une sortie fournissant un signal binaire d'horloge de bande de base, et deux échantillonneurs, appelés échantillonneurs respectivement de phase 74 et de quadrature 76, dont les entrées sont connectées à l'horloge 72 et à la sortie des filtres passe-bas anti-repliement respectivement de phase 66 et de quadrature 68, et dont les sorties fournissent les signaux numériques de bande de base en phase $N_I$ et en quadrature $N_Q$.

Dans le cas où les filtres passe-bas sont analogiques, chaque échantillonneur 74, 76 est en fait un convertisseur analogique numérique comportant un circuit de quantification (non représenté) pour, en plus de l'échantillonnage, quantifier les signaux analogiques de bande de base.

On remarquera que l'échantillonnage est réalisé loin dans la chaîne de réception, en particulier après le mélange 62, 64. Ainsi, l'échantillonnage peut être réalisé à une fréquence de bande de base, ce qui permet de réduire la consommation en énergie du double échantillonneur 70.

Généralement, le double échantillonneur 70 est suivi de filtres numériques (non représentés) ayant pour fonction de réaliser un vrai filtrage de canal. Ces filtres de canal sont généralement des filtres passe-bas, mais peuvent également être des filtres passe-bande. Dans les deux cas, ces filtres sont caractérisés par des pentes de coupure beaucoup plus raides que celles des filtres anti-repliement 66, 68.

On notera que le récepteur radio 50 a été décrit dans le cas d'un recalage du signal radiofréquence reçu en bande de base, mais qu'en variante, l'invention fonctionne aussi avec un récepteur radio convertissant le signal reçu en fréquence intermédiaire (hétérodynage).

En référence à la figure 8B, un récepteur 80 de signaux radiofréquence selon un deuxième mode de réalisation de l'invention comporte les mêmes éléments (mêmes références) que ceux du récepteur 50 jusqu'à l'obtention des deux signaux binaires mélangés respectivement en phase $B_I$ et en quadrature $B_Q$.

Dans ce mode de réalisation, on tire profit de l'oscillateur local 58 pour remplacer les filtres passe-bas 66, 68 par deux convertisseur analogique numérique Sigma Delta 82 et 84 capables aussi de façon classique de réaliser naturellement la fonction de filtrage passe-bas anti repliement. L'un des deux signaux d'oscillation locale, par exemple le signal $B_{OL\,90}$, est ainsi fourni aux deux convertisseurs Sigma Delta 82, 84 pour réaliser le suréchantillonnage propre aux convertisseurs Sigma Delta. En effet, la fréquence de l'oscillateur local 58 est suffisamment élevée pour produire un bon rapport de suréchantillonnage. En variante, il est également possible d'utiliser une autre horloge indépendante sans que cela ne nuise à la réception. Le trait interrompu vertical illustré sur la figure 8B au niveau des deux convertisseurs Sigma Delta 82, 84 représente symboliquement la frontière entre les signaux à temps continu, situés en amont dans la chaîne de réception, et les signaux échantillonnés, situés en aval. Les convertisseurs Sigma Delta 82, 84 étant bien connus de l'homme de l'art, ils ne seront pas davantage détaillés ici.

Dans ce mode de réalisation également, de façon classique et en raison de la présence des convertisseurs Sigma Delta 82, 84, le récepteur 80 comporte deux décimateurs 86, 88 disposés respectivement en sortie des deux convertisseurs 82, 84 pour réduire la fréquence des échantillons à une fréquence $f_s$ plus basse. Pour ce faire, le récepteur 80 comporte en outre un module 90 de génération d'un facteur N de décimation, capable de produire cette fréquence $f_s$ à partir de celle du signal d'oscillation locale $B_{OL\,90}$, et capable également de fournir le facteur de décimation N aux deux décimateurs 86, 88. De cette façon, les signaux numériques de bande de base en phase $N_I$ et en quadrature $N_Q$ mentionnés précédemment peuvent être fournis à la fréquence d'échantillonnage $f_s$ en sortie des deux décimateurs 86, 88. Un exemple de décimateur particulièrement efficace pouvant être employé pour les éléments 86 et 88 est un filtre de type CIC (de l'anglais « Cascaded Integrated Comb »).

Il apparaît clairement qu'un dispositif de quantification tel que celui décrit précédemment permet d'obtenir un signal quantifié sur très peu de bits (jusqu'à deux bits) sans trop de perte d'information et avec une bonne discrimination entre bruit et signal utile. Un domaine technique concerné par l'invention est celui des communications radio et des transmissions sans-fil, mais pas uniquement.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. En particulier, un dispositif de quantification selon l'invention peut être utilisé dans d'autres dispositifs qu'un récepteur de signaux radiofréquence. Par ailleurs, un dispositif de quantification selon l'invention peut fournir un signal de sortie quantifié sur plus de deux bits.

**Revendications**

1. Dispositif (10; 30) de quantification en temps continu d'un signal analogique d'entrée ($V_{in}$), pour la fourniture d'un signal de sortie à temps continu ($B_s$, $B_{env}$) quantifié sur plusieurs bits, comportant :

   - un circuit électronique (12) d'analyse de signe, conçu pour fournir un premier signal binaire à temps continu ($B_s$) représentatif d'un premier bit du signal de sortie, appelé bit de signe, prenant à tout instant une première valeur lorsque le signal d'entrée est positif et une deuxième valeur lorsque le signal d'entrée est négatif,
   - un circuit électronique (16) d'analyse d'enveloppe, comportant :

      • un comparateur/quantificateur (18 ; 32, 34) à deux entrées dont l'une reçoit le signal analogique d'entrée, conçu pour fournir en sortie du comparateur/quantificateur un deuxième signal quantifié à temps continu ($B_{env}$) représentatif d'au moins un deuxième bit du signal de sortie, appelé signal quantifié d'enveloppe, et
      • une boucle de rétroaction (20, 22) à conversion numérique analogique en temps continu du signal quantifié d'enveloppe ($B_{env}$), disposée entre la sortie et l'autre des deux entrées du comparateur/quantificateur (18 ; 32, 34),

   **caractérisé en ce que** le signal quantifié d'enveloppe ($B_{env}$) est un signal dont un filtrage passe-bas est représentatif de l'amplitude d'un signal d'enveloppe ($V_{env}$) du signal d'entrée, et **en ce que** la boucle de rétroaction (20, 22) comporte un filtre passe-bas (22) configuré de manière à reproduire, avec le comparateur/quantificateur (18 ; 32, 34), les éléments fonctionnels d'un opérateur Sigma Delta en temps continu.

2. Dispositif (10 ; 30) de quantification en temps continu selon la revendication 1, comportant un multiplieur (24) de signaux quantifiés à temps continu, ce multiplieur recevant en entrée le bit de signe ($B_s$) et le signal quantifié d'enveloppe ($B_{env}$) et fournissant en sortie le produit en temps continu des deux signaux qu'il reçoit en entrée.

3. Dispositif (10 ; 30) de quantification en temps continu selon la revendication 2, dans lequel :

   - le circuit électronique (16) d'analyse d'enveloppe est conçu pour fournir un signal binaire ($B_{env}$) en sortie du comparateur/quantificateur (18; 32, 34), ce signal binaire étant représentatif d'un unique deuxième bit du signal de sortie, appelé bit d'enveloppe,
   - la boucle de rétroaction (20, 22) est à conversion numérique analogique en temps continu et à un bit du bit d'enveloppe, et
   - le multiplieur (24) est une porte logique OU Exclusif.

4. Dispositif (10 ; 30) de quantification en temps continu selon l'une quelconque des revendications 1 à 3, dans lequel, le signal analogique d'entrée ($V_{in}$) étant à modulation autour d'une fréquence porteuse et de bande passante inférieure à la fréquence porteuse, le filtre passe-bas (22) présente une fréquence de coupure supérieure à la moitié de ladite bande passante.

5. Dispositif (10 ; 30) de quantification en temps continu selon l'une quelconque des revendications 1 à 4, dans lequel le circuit électronique (12) d'analyse de signe comporte un comparateur asynchrone (14).

6. Dispositif (10) de quantification en temps continu selon l'une quelconque des revendications 1 à 5, dans lequel le comparateur/quantificateur (18) du circuit électronique (16) d'analyse d'enveloppe comporte un comparateur à effet mémoire.

7. Dispositif (30) de quantification en temps continu selon l'une quelconque des revendications 1 à 6, dans lequel le comparateur/quantificateur (32, 34) du circuit électronique (16) d'analyse d'enveloppe comporte :

   - un comparateur asynchrone (32), et
   - une bascule RS (34) dont une première entrée est raccordée en sortie du comparateur asynchrone (32) du circuit électronique (16) d'analyse d'enveloppe et une deuxième entrée est raccordée en sortie du circuit électronique (12) d'analyse de signe.

8. Dispositif (30) de quantification en temps continu selon l'une quelconque des revendications 1 à 7, dans lequel le comparateur/quantificateur (32, 34) du circuit électronique (16) d'analyse d'enveloppe est suivi, dans le circuit électronique (16) d'analyse d'enveloppe, par une bascule D (40) présentant une entrée d'horloge alimentée par le bit de signe ($B_s$) fourni par le circuit électronique (12) d'analyse de signe.

9. Récepteur (50 ; 80) de signaux radiofréquence comportant :

   - une antenne (52) conçue pour capter un signal radiofréquence et le convertir en un signal électrique ($V_r$),
   - un dispositif (56) de quantification en temps continu selon l'une quelconque des revendications 1 à 8 pour quantifier en temps continu un signal analogique ($V_{in}$) d'entrée obtenu à partir du signal électrique ($V_r$) fourni par l'antenne (52),

- un circuit électronique (58, 60) d'oscillateur radio local, conçu pour générer deux signaux d'oscillation locale ($B_{OL\,0}$, $B_{OL\,90}$) en quadrature l'un de l'autre, et

- un circuit électronique double mélangeur (62, 64), conçu pour fournir deux signaux électriques binaires de bande de base ($B_I$, $B_Q$) en quadrature l'un de l'autre, ces deux signaux de bande de base correspondant au mélange du produit ($Q_{out}$) du bit de signe ($B_s$) et du signal quantifié d'enveloppe ($B_{env}$) avec respectivement les deux signaux d'oscillation locale ($B_{OL\,0}$, $B_{OL\,90}$).

10. Procédé de quantification en temps continu d'un signal analogique d'entrée ($V_{in}$), destiné à fournir un signal de sortie à temps continu ($B_s$, $B_{env}$) quantifié sur plusieurs bits, comportant les étapes suivantes :

- fournir (102) un premier signal binaire à temps continu ($B_s$) représentatif d'un premier bit du signal de sortie, appelé bit de signe, prenant à tout instant une première valeur lorsque le signal d'entrée est positif et une deuxième valeur lorsque le signal d'entrée est négatif,

- fournir (104) un deuxième signal quantifié à temps continu ($B_{env}$) représentatif d'au moins un deuxième bit du signal de sortie, appelé signal quantifié d'enveloppe, par une opération de comparaison/quantification comportant une comparaison du signal analogique d'entrée ($V_{in}$) avec un signal à temps continu ($V_{env}$) résultant d'une boucle de rétroaction à conversion numérique analogique en temps continu (106, 108) du signal quantifié d'enveloppe ($B_{env}$),

**caractérisé en ce que** le signal quantifié d'enveloppe ($B_{env}$) est un signal dont un filtrage passe-bas est représentatif de l'amplitude d'un signal d'enveloppe ($V_{env}$) du signal d'entrée, **en ce que** la boucle de rétroaction comporte un filtrage passe-bas (108) configuré de manière à reproduire, avec l'opération de comparaison/quantification, une opération Sigma Delta en temps continu, et **en ce que** le signal à temps continu ($V_{env}$) résultant de cette boucle de rétroaction est ledit signal d'enveloppe ($V_{env}$) du signal d'entrée.

**Patentansprüche**

1. Zeitkontinuierliche Quantifizierungsvorrichtung (10; 30) eines analogen Eingangssignals ($V_{in}$) für die Bereitstellung eines auf mehreren Bits quantifizierten zeitkontinuierlichen Ausgangssignals ($B_s$, $B_{env}$), aufweisend:

- einen elektronischen Zeichenanalyse-Schaltkreis (12), der konzipiert ist, um ein erstes zeitkontinuierliches binäres Signal ($B_s$) bereitzustellen, das für ein erstes Bit des Ausgangssignals, bezeichnet als Zeichenbit, repräsentativ ist, welches zu jedem Moment einen ersten Wert annimmt, wenn das Eingangssignal positiv ist, und einen zweiten Wert, wenn das Eingangssignal negativ ist,

- einen elektronischen Hüllanalyse-Schaltkreis (16), aufweisend:

- einen Komparator/Quantifizierer (18; 32, 34) mit zwei Eingängen, von denen der eine das analoge Eingangssignal empfängt, der konzipiert ist, um am Ausgang des Komparators/Quantifizierers ein zweites zeitkontinuierliches quantifiziertes Signal ($B_{env}$) bereitzustellen, das für mindestens ein zweites Bit des Ausgangssignals, bezeichnet als quantifiziertes Hüllsignal, repräsentativ ist, und

- eine Rückkopplungsschleife (20, 22) für die zeitkontinuierliche digitalanaloge Konvertierung des quantifizierten Hüllsignals ($B_{env}$), die zwischen dem Ausgang und dem anderen der zwei Eingänge des Komparators/Quantifizierers (18; 32, 34) angeordnet ist,

**dadurch gekennzeichnet, dass** das quantifizierte Hüllsignal ($B_{env}$) ein Signal ist, von dem eine Tiefpassfilterung für die Amplitude eines Hüllsignals ($V_{env}$) des Eingangssignals repräsentativ ist, und dadurch, dass die Rückkopplungsschleife (20, 22) einen Tiefpassfilter (22) aufweist, der konfiguriert ist, um mit dem Komparator/Quantifizierer (18; 32, 34) die funktionellen Elemente eines zeitkontinuierlichen Sigma-Delta-Operators zu reproduzieren.

2. Zeitkontinuierliche Quantifizierungsvorrichtung (10; 30) nach Anspruch 1, aufweisend einen Multiplizierer (24) zeitkontinuierlicher quantifizierter Signale, wobei dieser Multiplizierer am Eingang das Zeichenbit ($B_s$) und das quantifizierte Hüllsignal ($B_{env}$) empfängt und am Ausgang das zeitkontinuierlichen Produkt der zwei Signale, die er am Eingang empfängt, bereitstellt.

3. Zeitkontinuierliche Quantifizierungsvorrichtung (10; 30) nach Anspruch 2, wobei:

- der elektronische Hüllanalyse-Schaltkreis (16) konzipiert ist, um ein binäres Signal ($B_{env}$) am Ausgang des Komparators/Quantifizierers (18; 32, 34) bereitzustellen, wobei dieses binäre Signal für ein einziges zweites Bit des Ausgangssignals, bezeichnet als Hüllbit, repräsentativ ist,

- die Rückkopplungsschleife (20, 22) mit zeitkontinuierlicher digitalanaloger Konvertierung und mit einem Bit des Hüllbits ist, und
- der Multiplizierer (24) ein logischer XOR-Port ist.

4. Zeitkontinuierliche Quantifizierungsvorrichtung (10; 30) nach einem der Ansprüche 1 bis 3, wobei, da das analoge Eingangssignal ($V_{in}$) mit Modulation um eine Trägerfrequenz und Bandbreite unter der Trägerfrequenz ist, der Tiefpassfilter (22) eine Sperrfrequenz aufweist, die größer als die Hälfte der Bandbreite ist.

5. Zeitkontinuierliche Quantifizierungsvorrichtung (10; 30) nach einem der Ansprüche 1 bis 4, wobei der elektronische Zeichenanalyse-Schaltkreis (12) einen Asynchron-Komparator (14) aufweist.

6. Zeitkontinuierliche Quantifizierungsvorrichtung (10) nach einem der Ansprüche 1 bis 5, wobei der Komparator/Quantifizierer (18) des elektronischen Hüllanalyse-Schaltkreises (16) einen Komparator mit Memory-Effekt aufweist.

7. Zeitkontinuierliche Quantifizierungsvorrichtung (30) nach einem der Ansprüche 1 bis 6, wobei der Komparator/Quantifizierer (32, 34) des elektronischen Hüllanalyse-Schaltkreises (16) aufweist:

- einen Asynchron-Komparator (32), und
- einen Flipflop RS (34), von dem ein erster Eingang am Ausgang des Asynchron-Komparators (32) des elektronischen Hüllanalyse-Schaltkreises (16) angeschlossen ist und ein zweiter Eingang am Ausgang des elektronischen Zeichenanalyse-Schaltkreises (12) angeschlossen ist.

8. Zeitkontinuierliche Quantifizierungsvorrichtung (30) nach einem der Ansprüche 1 bis 7, wobei dem Komparator/Quantifizierer (32, 34) des elektronischen Hüllanalyse-Schaltkreises (16) in dem elektronischen Hüllanalyse-Schaltkreis (16) ein Flipflop D (40) folgt, der einen Takteingang aufweist, der von dem elektronischen Zeichenanalyse-Schaltkreis (12) bereitgestellten Zeichenbit ($B_s$) versorgt wird.

9. Funkfrequenzsignalempfänger (50; 80), aufweisend:

- eine Antenne (52), die konzipiert ist, um ein Funkfrequenzsignal zu empfangen und es in ein elektrisches Signal ($V_r$) umzuwandeln,
- eine zeitkontinuierliche Quantifizierungsvorrichtung (56) nach einem der Ansprüche 1 bis 8 für die zeitkontinuierliche Quantifizierung eines analogen Eingangssignals ($V_{in}$), erhalten auf der Basis des von der Antenne (52) bereitgestellten elektrischen Signals ($V_r$),

- einen lokalen elektronischen Funkoszillator-Schaltkreis (58, 60), der konzipiert ist, um zwei lokale Oszillationssignale ($B_{OL\,0}$, $B_{OL\,90}$) in Quadratur zueinander zu erzeugen, und
- einen elektronischen Doppelmix-Schaltkreis (62, 64), der konzipiert ist, um zwei binäre elektrische Basisband-Signale ($B_I$, $B_Q$) in Quadratur zueinander bereitzustellen, wobei diese zwei Basisband-Signale dem Mix des Produkts ($Q_{out}$) des Zeichenbits ($B_s$) und des quantifizierten Hüllsignals ($B_{env}$) mit jeweils den zwei lokalen Oszillationssignalen ($B_{OL\,0}$, $B_{OL\,90}$) entsprechen.

10. Zeitkontinuierliches Quantifizierungsverfahren eines analogen Eingangssignals ($V_{in}$) für die Bereitstellung eines auf mehreren Bits quantifizierten zeitkontinuierlichen Ausgangssignals ($B_s$, $B_{env}$), aufweisend die folgenden Schritte:

- Bereitstellen (102) eines ersten zeitkontinuierlichen binären Signals ($B_s$), das für ein erstes Bit des Ausgangssignals, bezeichnet als Zeichenbit, repräsentativ ist, welches zu jedem Moment einen ersten Wert annimmt, wenn das Eingangssignal positiv ist, und einen zweiten Wert, wenn das Eingangssignal negativ ist,
- Bereitstellen (104) eines zweiten zeitkontinuierlichen quantifizierten Signals ($B_{env}$), das für mindestens ein zweites Bit des Ausgangssignals, bezeichnet als quantifiziertes Hüllsignal, repräsentativ ist, mittels eines Vergleichs-/Quantifizierungsvorgangs, aufweisend einen Vergleich des analogen Eingangssignals ($V_{in}$) mit einem zeitkontinuierlichen Signal ($V_{env}$), das aus einer Rückkopplungsschleife (106, 108) mit zeitkontinuierlicher digitalanaloger Konvertierung des quantifizierten Hüllsignals ($B_{env}$) resultiert,

dadurch gekennzeichnet, dass das quantifizierte Hüllsignal ($B_{env}$) ein Signal ist, von dem eine Tiefpassfilterung für die Amplitude eines Hüllsignals ($V_{env}$) des Eingangssignals repräsentativ ist, dadurch, dass die Rückkopplungsschleife eine Tiefpassfilterung (108) aufweist, die derart konfiguriert ist, dass mit dem Vergleichs-/Quantifizierungsvorgang eine zeitkontinuierliche Sigma-Delta-Operation reproduziert wird, und dadurch, dass das zeitkontinuierliche Signal ($V_{env}$), das aus dieser Rückkopplungsschleife resultiert, das Hüllsignal ($V_{env}$) des Eingangssignals ist.

**Claims**

1. Continuous-time quantization device (10; 30) of an analog input signal ($V_{in}$), for the supplying of a con-

tinuous-time output signal ($B_s$, $B_{env}$) quantized using a plurality of bits, comprising:

- a sign analysis electronic circuit (12), designed to supply a first continuous-time binary signal ($B_s$) representative of a first bit of the output signal, called sign bit, having at any instant a first value when the input signal is positive and a second value when the input signal is negative,
- an envelope analysis electronic circuit (16), comprising:

• a comparator/quantizer (18; 32, 34) with two inputs one of which receives the analog input signal, designed to supply as output of the comparator/quantizer a second continuous-time quantized signal ($B_{env}$) representative of at least a second bit of the output signal, called quantized envelope signal, and
• a feedback loop (20, 22) with continuous-time digital-to-analog conversion of the quantized envelope signal ($B_{env}$), arranged between the output and the other of the two inputs of the comparator/quantizer (18; 32, 34),

**characterized in that** the quantized envelope signal ($B_{env}$) is a signal of which a low pass filtering is representative of the amplitude of an envelope signal ($V_{env}$) of the input signal, and **in that** the feedback loop (20, 22) comprises a low pass filter (22) configured to reproduce, together with the comparator/quantizer (18; 32, 34), the functional elements of a continuous-time Sigma Delta operator.

2. Continuous-time quantization device (10; 30) according to claim 1, comprising a continuous-time quantized signal multiplier (24), with this multiplier receiving as input the sign bit ($B_s$) and the quantized envelope signal ($B_{env}$) and supplying as output the continuous-time product of the two signals that it receives as input.

3. Continuous-time quantization device (10; 30) according to claim 2, wherein:

- the envelope analysis electronic circuit (16) is designed to supply a binary signal ($B_{env}$) at the output of the comparator/quantizer (18; 32, 34), with this binary signal being representative of a single second bit of the output signal, called envelope bit,
- the feedback loop (20, 22) is with continuous-time and with one bit digital-to-analog conversion of the envelope bit, and
- the multiplier (24) is a logic Exclusive OR gate.

4. Continuous-time quantization device (10; 30) according to any of claims 1 to 3, wherein, the analog input signal ($V_{in}$) being with modulation around a carrier frequency and with bandwidth less than the carrier frequency, the low pass filter (22) has a cutoff frequency greater than half of said bandwidth.

5. Continuous-time quantization device (10; 30) according to any of claims 1 to 4, wherein the sign analysis electronic circuit (12) comprises an asynchronous comparator (14).

6. Continuous-time quantization device (10) according to any of claims 1 to 5, wherein the comparator/quantizer (18) of the envelope analysis electronic circuit (16) comprises a memory effect comparator.

7. Continuous-time quantization device (30) according to any of claims 1 to 6, wherein the comparator/quantizer (32, 34) of the envelope analysis electronic circuit (16) comprises:

- an asynchronous comparator (32), and
- an RS flip-flop (34) of which a first input is connected as output of the asynchronous comparator (32) of the envelope analysis electronic circuit (16) and a second input is connected as output of the sign analysis electronic circuit (12).

8. Continuous-time quantization device (30) according to any of claims 1 to 7, wherein the comparator/quantizer (32, 34) of the envelope analysis electronic circuit (16) is followed, in the envelope analysis electronic circuit (16), by a D flip-flop (40) having a clock input supplied by the sign bit ($B_s$) provided by the sign analysis electronic circuit (12).

9. Receiver (50; 80) of radio frequency signals comprising:

- an antenna (52) designed to capture a radio frequency signal and convert it into an electric signal ($V_r$),
- a continuous-time quantization device (56) according to any of claims 1 to 8 for quantizing in continuous time an analog input signal ($V_{in}$) obtained using the electric signal ($V_r$) supplied by the antenna (52),
- an electronic circuit (58, 60) of a local radio oscillator, designed to generate two local oscillation signals ($B_{OL\,0}$, $B_{OL\,90}$) in quadrature with one another, and
- a double mixer electronic circuit (62, 64), designed to supply two binary baseband electric signals ($B_I$, $B_Q$) in quadrature with one another, with these two baseband signals corresponding to the mixture of the product ($Q_{out}$) of the sign bit ($B_s$) and of the quantized envelope signal

($B_{env}$) with respectively the two local oscillation signals ($B_{OL\,0}$, $B_{OL\,90}$).

10. Continuous-time quantization method of an analog input signal ($V_{in}$), intended to provide a continuous-time output signal ($B_s$, $B_{env}$) quantized using a plurality of bits, comprising the following steps:

   - provide (102) a first continuous-time binary signal ($B_s$) representative of a first bit of the output signal, called sign bit, having at any instant a first value when the input signal is positive and a second value when the input signal is negative,
   - provide (104) a second continuous-time quantized signal ($B_{env}$) representative of at least a second bit of the output signal, called quantized envelope signal, via a comparison/quantization operation comprising a comparison of the analog input signal ($V_{in}$) with a continuous-time signal ($V_{env}$) resulting from a feedback loop with continuous-time digital-to-analog conversion (106, 108) of the quantized envelope signal ($B_{env}$),

   **characterized in that** the quantized envelope signal ($B_{env}$) is a signal of which a low pass filtering is representative of the amplitude of an envelope signal ($V_{env}$) of the input signal, **in that** the feedback loop comprises a low pass filtering (108) configured to reproduce, together with the comparison/quantization operation, a continuous-time Sigma Delta operation, and **in that** the continuous-time signal ($V_{env}$) resulting from this feedback loop is said envelope signal ($V_{env}$) of the input signal.

## *Figure 1*

## *Figure 2*

## Figure 3

## Figure 4

## Figure 5A

$Q_{out}$
$B_s$
$B_{env}$
$B$
$V_{env}$
$V_{in}$

## Figure 5B

$Q_{out}$
$B_s$
$B_{env}$
$B$
$V_{env}$
$V_{in}$

## Figure 7A

## Figure 7B

## Figure 6

## Figure 8A

## Figure 8B

## RÉFÉRENCES CITÉES DANS LA DESCRIPTION

**Documents brevets cités dans la description**

- FR 2922388 B1

- FR 2959079 B1

**Littérature non-brevet citée dans la description**

- **DE I. WANG ; S. LIU.** 1V 5-bit 5GS/s CMOS ADC for UWB receivers. *International Symposium on VLSI Design, Automation and Test, 2007, VLSI-DAT 2007,* 25 Avril 2007, 1-4

- **DE S-W CHEN ; E. W. BRODERSEN.** A Subsampling Radio Architecture for Ultrawideband Communications. *IEEE Transactions on Signal Processing,* Octobre 2007, vol. 55 (10), 5018-5031